# EUROPEAN PATENT APPLICATION

(11) **EP 4 527 900 A1**
(43) Date of publication of application: **26.03.2025**
(21) Application number: 23806635.1
(22) Date of filing: 07.04.2023
(51) Int. Cl.: C09D 11/03, C09D 11/38, H01L 31/0216, H01L 31/054, C09D 11/50, H01L 31/055, C09D 11/101, H01L 31/02, H01L 31/048, C09C 1/62

(54) **INK AND COLOR PHOTOVOLTAIC ASSEMBLY**

(30) Priority: 16.05.2022 CN 202210529641; 29.01.2023 CN 202310078270
(71) Applicant: Longi Solar Technology Co., Ltd, Xi'an Shaanxi 710018 (CN)
(72) Inventor: WANG, Shencun, Xi'an, Shaanxi 710018 (CN); ZHANG, Song, Xi'an, Shaanxi 710018 (CN); SHAN, Kangkang, Xi'an, Shaanxi 710018 (CN)
(74) Representative: Pfenning, Meinig & Partner mbB
(86) International application number: PCT/CN2023/086789
(87) International publication number: WO 2023/221679

(57) **Abstract**

The present application provides an ink and a colored photovoltaic module containing the ink. The ink includes an infrared reflective powder and a color developing powder. In the ink, the content in percentage by weight of the infrared reflective powder is 0.1% to 30%, and preferably 5% to 15%, and the content in percentage by weight of the color developing powder is 0.1% to 20%, and preferably 1% to 5%. By optimizing the color realization method, the present application ensures a high efficiency of the module while colors are attained. In addition, the addition of the infrared reflective powder renders a front panel glass of the module with a higher reflectivity for infrared rays, so that the working temperature of the module is reduced, thereby increasing the power generation capacity and prolonging the service life of the module.

## Description

### CROSS-REFERENCE TO RELATED APPLICATIONS

The present application claims priority to Chinese Patent Application No. 202210529641.0 filed with the China National Intellectual Property Administration on May 16, 2022 and entitled "INK AND COLORED PHOTOVOLTAIC MODULE", which is incorporated herein by reference in its entirety. The present application claims priority to Chinese Patent Application No. 202310078270.3 filed with the China National Intellectual Property Administration on January 29, 2023 and entitled "INK AND COLORED PHOTOVOLTAIC MODULE", which is incorporated herein by reference in its entirety.

### TECHNICAL FIELD

The present application relates to the technical field of solar cells, and particularly, to an ink and a colored photovoltaic module.

### BACKGROUND

As a tool for receiving and converting light energy, photovoltaic modules have achieved high efficiency after long-term technology innovation and upgrade, and have been widely used in large-scale terrestrial photovoltaic power stations. As the amount of photovoltaic installations increases, available land resources have been almost used up, and the use of vast building areas as sunlight receiving surfaces becomes an optimum choice for photovoltaic installation. The photovoltaic installation on buildings can not only increase the energy revenues, but also reduce the energy consumption of buildings. Moreover, the power generated on the building can be used by the building itself to reduce the loss caused by long-distance power transmission. However, the color of photovoltaic cells is usually dark blue or black, which is monotonous and cannot meet the requirement for diversified appearances of buildings. The photovoltaic cell technologies include thin-film cell technology, such as cadmium telluride and copper indium gallium selenide, etc. However, the efficiency of these technologies is usually low. As a mature photovoltaic power generation technology, crystalline silicon has reached an efficiency of 24% or higher in mass production, and therefore is a preferred technology for building integrated photovoltaic. One method to meet the requirements for diversified colors of photovoltaic modules is to add an inorganic or organic pigment to an adhesive film, such as a colored adhesive film. However, such a method is not a good choice for realization of colors of photovoltaic modules because it greatly reduces the efficiency of photovoltaic modules because of the absorption of light by the pigment, and has the risk of color fading. Another method is to apply a colored coating on the surface of the solar cell. However, in this method, it is difficult to control the thickness of the coating, and the color cannot be made uniform, resulting in as a non-aesthetic appearance. Therefore, it is necessary to choose a better color realization method.

Moreover, when the photovoltaic module receives irradiation of sunlight during working, part of energy of the light (with a wavelength of 380 nm to 1100 nm) is absorbed by the silicon solar cell and converted into electric energy and heat. The other part of energy, particularly infrared light with a wavelength of 1100 nm or higher, cannot be converted into electric energy by the solar cell, but can be absorbed and converted into heat. The energy of light with a wavelength of 1100 nm or higher accounts for about 30% of the total energy of sunlight, and will generate lots of heat after being absorbed by the photovoltaic module, leading to an increase in the temperature of the photovoltaic module. After the working temperature of the photovoltaic module rises, the power output of the photovoltaic module is reduced, and aging and degradation of the photovoltaic module tend to occur because the polymer material is more active at high temperature. When the photovoltaic module works in a large-scale power station, its front and back sides are both exposed to flowing air, with a high heat transfer coefficient, so the heat generated can be dissipated in time. In such an environment, the working temperature will not be too high, and is generally not more than 70°C. However, when photovoltaic module is used on a building, the back side of the module is generally arranged opposite to a solid wall, thermal insulation cotton, etc., with poor air flow and no heat dissipation passage at the back side. As a result, the working temperature of the photovoltaic module rises greatly, reaching 90°C or higher. Under such high-temperature conditions, the service life of the module will be greatly reduced. Therefore, there is a need to optimize the existing designs or materials, to reduce the working temperature of the module.

### SUMMARY

In view of the problems existing in the prior art, the present application provides an ink and a colored photovoltaic module.

Particularly, the present application relates to the following aspects.

An ink is provided. The ink includes an infrared reflective powder and a color developing powder, where in the ink, the content in percentage by weight of the infrared reflective powder is 0.1% to 30%, and preferably 5% to 15%; and the content in percentage by weight of the color developing powder is 0.1% to 20%, and preferably 1% to 5%.

Optionally, the infrared reflective powder is highly transmissive to light with a wavelength of 300 nm to 1100 nm, and highly reflective to infrared light with a wavelength of 1100 nm to 5000 nm.

Optionally, the infrared reflective powder is of transparent or translucent flakes with a thickness of 0.5 µm to 5 µm, and the color developing powder is of transparent or translucent flakes with a thickness of 0.5 µm to 5 µm.

Optionally, the infrared reflective powder includes a first dielectric film layer, a metal film layer, and a second dielectric film layer laminated in sequence. The first dielectric film layer has a thickness of 10 nm to 100 nm, the metal film layer has a thickness of 3 nm to 30 nm, and the second dielectric film layer has a thickness of 10 nm to 100 nm.

Optionally, the infrared reflective powder is one or more selected from ZnS/Ag/ZnS, SiO₂/Ag/TiO₂, Al₂O₃/Ag/Al₂O₃, and ZnO/Ag/ZnS, and preferably ZnS/Ag/ZnS.

Optionally, the ink is a high-temperature ink, including the infrared reflective powder, the color developing powder, a glass powder, and an organic solvent.

Optionally, in the high-temperature ink, the content in percentage by weight of the infrared reflective powder is 0.1% to 30%, and preferably 5% to 15%; the content in percentage by weight of the color developing powder is 0.1% to 20%, and preferably 1% to 5%; the content in percentage by weight of the glass power is 30% to 70%; and the content in percentage by weight of the organic solvent is 10% to 40%.

Optionally, the ink is a low-temperature ink, including the infrared reflective powder, the color developing powder, and an organic solvent.

Optionally, in the low-temperature ink, the content in percentage by weight of the infrared reflective powder is 0.1% to 30%, and preferably 5% to 15%; the content in percentage by weight of the color developing powder is 0.1% to 20%, and preferably 1% to 5%; and the content in percentage by weight of the organic solvent is 70% to 99.9%.

A colored photovoltaic module is provided. The colored photovoltaic module includes a colored glass layer, a solar cell chip layer, a first lower flexible adhesive film layer, a reinforced adhesive film layer, a second lower flexible adhesive film layer, and a back glass layer laminated in sequence.

Optionally, the colored glass layer includes a front glass layer, a colored enamel layer, and an upper adhesive film layer laminated in sequence. The upper adhesive film layer is closer to the solar cell chip layer than the front glass layer and the colored enamel layer are.

Optionally, the colored enamel layer includes an infrared reflective powder and a color developing powder. In the colored enamel layer, the content in percentage by weight of the infrared reflective powder is 0.1% to 30%, and preferably 5% to 15%; and the content in percentage by weight of the color developing powder is 0.1% to 20%, and preferably 1% to 5%.

Optionally, the colored enamel layer has a thickness of 5 µm to 100 µm, and preferably 10 µm to 30 µm.

Optionally, the colored enamel layer is formed of any ink described above.

Optionally, the colored glass layer includes a front glass layer and an upper adhesive film layer laminated in sequence. The upper adhesive film layer is closer to the solar cell chip layer than the front glass layer is.

The upper adhesive film layer includes an infrared reflective powder and a color developing powder. In the upper adhesive film layer, the content in percentage by weight of the infrared reflective powder is 0.1% to 30%, and preferably 5% to 15%; and the content in percentage by weight of the color developing powder is 0.1% to 20%, and preferably 1% to 5%.

Optionally, the infrared reflective powder is highly transmissive to light with a wavelength of 300 nm to 1100 nm, and highly reflective to infrared light with a wavelength of 1100 nm to 5000 nm.

Optionally, the infrared reflective powder is of transparent or translucent flakes with a thickness of 0.5 µm to 5 µm, and the color developing powder is of transparent or translucent flakes with a thickness of 0.5 µm to 5 µm.

Optionally, the infrared reflective powder includes a first dielectric film layer, a metal film layer, and a second dielectric film layer laminated in sequence. The first dielectric film layer has a thickness of 10 nm to 100 nm, the metal film layer has a thickness of 3 nm to 30 nm, and the second dielectric film layer has a thickness of 10 nm to 100 nm.

Optionally, the infrared reflective powder is one or more selected from ZnS/Ag/ZnS, SiO₂/Ag/TiO₂, Al₂O₃/Ag/Al₂O₃, and ZnO/Ag/ZnS, and preferably ZnS/Ag/ZnS.

A colored photovoltaic module is provided. The colored photovoltaic module includes a front glass layer, upper adhesive film layer, a solar cell chip layer, a lower adhesive film layer, and a back sheet laminated in sequence. The photovoltaic module includes an infrared reflective powder and a color developing powder on or in a front radiation receiving side thereof.

Optionally, the colored photovoltaic module is highly transmissive to light with a wavelength of 300 nm to 1100 nm, and highly reflective to infrared light with a wavelength of 1100 nm to 5000 nm.

Optionally, the infrared reflective powder is of transparent or translucent flakes with a thickness of 0.5 µm to 5 µm, and the color developing powder is of transparent or translucent flakes with a thickness of 0.5 µm to 5 µm.

Optionally, the infrared reflective powder includes a first dielectric film layer, a metal film layer, and a second dielectric film layer laminated in sequence. The first dielectric film layer has a thickness of 10 nm to 100 nm, the metal film layer has a thickness of 3 nm to 30 nm, and the second dielectric film layer has a thickness of 10 nm to 100 nm.

Optionally, the infrared reflective powder is one or more selected from ZnS/Ag/ZnS, SiO₂/Ag/TiO₂, Al₂O₃/Ag/Al₂O₃, and ZnO/Ag/ZnS, and preferably ZnS/Ag/ZnS.

Optionally, the colored photovoltaic module includes a colored enamel layer arranged between the front glass layer and the upper adhesive film layer or at an air side of the front glass layer. The colored enamel layer includes the infrared reflective powder and the color developing powder.

Optionally, the colored enamel layer is formed of any ink described above.

Optionally, the upper adhesive film layer includes the infrared reflective powder and the color developing powder.

Optionally, in the upper adhesive film layer, the content in percentage by weight of the infrared reflective powder is 0.1% to 30%, and preferably 5% to 15%; and the content in percentage by weight of the color developing powder is 0.1% to 20%, and preferably 1% to 5%.

Optionally, the lower adhesive film layer includes a first lower flexible adhesive film layer, a reinforced adhesive film layer, and a second lower flexible adhesive film layer laminated in sequence.

By optimizing a color realization method, the present application ensures a high efficiency of the module while colors are attained. In addition, the addition of the infrared reflective powder renders a front panel glass of the module with a higher reflectivity for infrared rays, so that the working temperature of the module is reduced, thereby increasing the power generation capacity and prolonging the service life of the module.

The above description is only a summary of the technical solutions of the present invention. To make the technical means of the present invention clearer and implementable in accordance with the disclosure of the specification, and make the above and other objects, and the features and advantages of the present invention more comprehensible, specific embodiments of the present invention will be described below.

### BRIEF DESCRIPTION OF THE DRAWINGS

In order to describe the technical solutions according to the embodiments of the present invention or in the prior art more clearly, the drawings needed to be used in the embodiments or in the prior art will be described briefly below. Apparently, the drawings in the following description show some embodiments of the present invention. Other drawings can be obtained by a person of ordinary skill in the art from these accompanying drawings without creative efforts.
FIG. 1 schematically shows a colored photovoltaic module of the present application.
FIG. 2 shows a surface reflectance curve of a photovoltaic module prepared in Example 1.
FIG. 3 schematically shows another colored photovoltaic module of the present application.
FIG. 4 schematically shows another colored photovoltaic module of the present application.
1: front glass layer, 2: colored enamel layer, 3: upper adhesive film layer, 4: solar cell chip layer, 5: first lower flexible adhesive film layer, 6: reinforced adhesive film layer, 7: second lower flexible adhesive film layer, 8: back glass layer, 9: lower adhesive film layer, 10: back sheet.

### DETAILED DESCRIPTION

In order to make the objects, technical solutions, and advantages of the embodiments of the present invention clearer, the technical solutions according to the embodiments of the present invention will be clearly and completely described with reference to drawings in the embodiments of the present invention. Apparently, the embodiments described are merely some embodiments, but not all of the embodiments of the present application. All other embodiments obtained by a person of ordinary skill in the art based on the embodiments of the present invention without creative efforts shall fall within the protection scope of the present invention.

The present application is further described below in conjunction with embodiments. It is to be understood that the embodiments are merely used to illustrate and elaborate the present invention, but are not intended to limit the present application.

All technical and scientific terms used in the specification have the same meaning as commonly understood by those skilled in the art, unless otherwise defined. Although similar or identical methods and materials can be used in experiments or practical applications, the materials and methods are described hereinafter. In case of contradictions, the definitions in this specification shall prevail. In addition, the materials, methods and examples are for illustration only, and not for limitation. Hereinafter, the present application is further described with reference to specific embodiments, which, however, is not intended to limit the scope of the present application.

The present application provides an ink. The ink includes an infrared reflective powder and a color developing powder. In the ink, the content in percentage by weight of the infrared reflective powder in the ink is 0.1% to 30%, for example, 0.1%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, or 30%, and preferably 5%% to 15%; and the content in percentage by weight of the color developing powder is 0.1% to 20%, for example, 0.1%, 1%, 2%, 3%, 4%, 5%, 6%, 7%, 8%, 9%, 10%, 11%, 12%, 13%, 14%, 15%, 16%, 17%, 18%, 19%, or 20%, and preferably 1% to 5%.

The infrared reflective powder is a powder able to reflect infrared light, which is preferably highly transmissive to light with a wavelength of 300 nm to 1100 nm, and highly reflective to infrared light with a wavelength of 1100 nm to 5000 nm.

In a specific embodiment, the infrared reflective powder being highly transmissive to light with a wavelength of 300 nm to 1100 nm means that the transmittance to light with a wavelength of 300 nm to 1100 nm is at least 50%, for example, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

In a specific embodiment, the infrared reflective powder being highly reflective to infrared light with a wavelength of 1100 nm to 5000 nm means that the reflectance to infrared light with a wavelength of 1100 nm to 5000 nm is at least 40%, for example, 40%, 45%, 50%, 55%, 60%, 65%, 70%, 75%, 80%, 85%, or 90%.

The infrared reflective powder is of transparent or translucent flakes with a thickness of 0.5 µm to 5 µm, for example 0.5 µm, 1 µm, 1.5 µm, 2 µm, 2.5 µm, 3 µm, 3.5 µm, 4.0 µm, 4.5 µm, or 5 µm. The infrared reflective powder is of transparent or translucent flakes itself, causing little shielding on and absorption of incident light, and not leading to the decrease in transmittance of the incident light.

In a specific embodiment, the infrared reflective powder has a three-layer structure, including a first dielectric film layer, a metal film layer, and a second dielectric film layer laminated in sequence. The first dielectric film layer has a thickness of 10 nm to 100 nm, for example, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, or 100 nm. The metal film layer has a thickness of 3 nm to 30 nm, for example, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, 21 nm, 22 nm, 23 nm, 24 nm, 25 nm, 26 nm, 27 nm, 28 nm, 29 nm, or 30 nm. The second dielectric film layer has a thickness of 10 nm to 100 nm, for example, 10 nm, 15 nm, 20 nm, 25 nm, 30 nm. 35 nm, 40 nm, 45 nm, 50 nm, 55 nm, 60 nm, 65 nm, 70 nm, 75 nm, 80 nm, 85 nm, 90 nm, 95 nm, or 100 nm.

The first dielectric film layer and the second dielectric film layer may be selected from ZnS, ZnO, ZnSe, Bi₂O₃, NbO₅, or CeO₂, and the materials of the first dielectric film layer and the second dielectric film layer may be the same or different. The material of the metal film layer may be selected from Ag, Au, Cu, Mo, and Al. The infrared reflective powder can adjust the reflection and transmission of light in different wave bands by means of the materials and thickness of the dielectric film layers and metal film layer.

In a specific embodiment, the infrared reflective powder is one or more selected from ZnS/Ag/ZnS, SiO₂/Ag/TiO₂, Al₂O₃/Ag/Al₂O₃, and ZnO/Ag/ZnS, and preferably ZnS/Ag/ZnS. ZnS/Ag/ZnS is used as an example, ZnS/Ag/ZnS includes a first dielectric film layer, a metal film layer, and a second dielectric film layer laminated in sequence. The first dielectric film layer and the second dielectric film layer are ZnS, and the metal film layer is Ag. A thickness of the ZnS layer is 10 nm to 100 nm, and a thickness of the Ag layer is 3 nm to 30 nm.

In a specific embodiment, for example, the infrared reflective powder may be an infrared reflective powder prepared to have the above structure or directly purchased. For example, the ZnS/Ag/ZnS infrared reflective powder may be prepared by a method including the following steps. A Si(111) wafer having one polished side surface and planar K9 glass with a thickness of 2 mm are used as a substrate, and ZnS is deposited by electron beam evaporation using a vacuum box coater. After a first layer of ZnS is deposited, a Ag film layer is prepared by resistive thermal evaporation in the vacuum box coater using high-purity silver particles as an evaporation source. Then, a third layer of ZnS film is prepared by the same method as that for the first layer of ZnS. After the multilayer film is prepared, it is peeled off from the substrate and crushed, to obtain the infrared reflective powder.

The color developing powder may be any color developing powder available in the art, for example, a multilayer oxide composed of metal oxides of titanium, aluminum, silicon, tin, zirconium, or zinc, a multilayer structure formed by metal oxides such as TiO₂ and natural mica or synthetic mica that can produce different colors through optical interference, or a multilayer oxide with micro-nano structure features. The color developing powder is of transparent or translucent flakes with a thickness of 0.5 µm to 5 µm, for example 0.5 µm, 1 µm, 1.5 µm, 2 µm, 2.5 µm, 3 µm, 3.5 µm, 4.0 µm, 4.5 µm, or 5 µm. The transparent or translucent flakes will not reduce the transmittance to the front light. Moreover, when the infrared reflective powder and the color developing powder are arranged on or in a front radiation receiving side of the photovoltaic module, the infrared reflective powder is dispersed in the ink to form multiple optical scattering centers, which work with the color developing powder to increase the secondary reflection of the light, thereby increasing the transmittance of the incident light and improving the power generation efficiency. Moreover, after the light is scattered, the optically variable defect is further reduced, to improve the aesthetics of the whole module.

In a specific embodiment, the color developing powder may be any substance that produces different colors through optical interference, such as commercially available or self-prepared blue pearlescent powder and red multi-layer oxide nano-powder.

For example, the red multi-layer oxide nano-powder may be prepared by the following method: K9 glass is used as a substrate, a release agent is coated on the glass surface, TiO₂ and SiO₂ materials are sequentially deposited as films on the substrate by electron beam deposition using a vacuum box coater, to form a multi-layer oxide film. After deposition, the film is released and crushed to obtain a red multi-layer oxide nano-powder.

The ink of the present application may be a high-temperature ink or a low-temperature ink. When the ink is a high-temperature ink, the ink of the present application includes the infrared reflective powder, the color developing powder, a glass powder, and an organic solvent. The glass powder is a mixture of silica, bismuth oxide, boron oxide, zinc oxide, potassium carbonate, titania, zirconia, alumina, calcium oxide, strontium oxide, a glass reinforcing agent, and a glass refining agent, which is melted and crushed.

In the high-temperature ink, the content in percentage by weight of the infrared reflective powder is 0.1% to 30%, for example, 0.1%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, or 30%, and preferably 5%% to 15%. The content in percentage by weight of the color developing powder is 0.1% to 20%, for example, 0.1%, 1%, 2%, 3%, 4%, 5%, 6%, 7%, 8%, 9%, 10%, 11%, 12%, 13%, 14%, 15%, 16%, 17%, 18%, 19%, or 20%, and preferably 1%% to 5%. The content in percentage by weight of the glass power is 30% to 70%, for example, 30%, 35%, 40%, 45%, 50%, 55%, 60%, 65%, or 70%. The content in percentage by weight of the organic solvent is 10% to 40%, for example, 10%, 15%, 20%, 25%, 30%, 35%, or 40%.

The organic solvent is selected from hexanediol acrylate, a functional acrylate, a coupling agent, a photocatalyst, and other resins. The materials of the infrared reflective powder and the color developing powder are as described above.

When the ink is a low-temperature ink, the ink includes the infrared reflective powder, the color developing powder and an organic solvent. The materials of the infrared reflective powder, the color developing powder and the organic solvent are as described above.

In the low-temperature ink, the content in percentage by weight of the infrared reflective powder is 0.1% to 30%, for example, 0.1%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, and preferably 5%% to 15%. The content in percentage by weight of the color developing powder is 0.1% to 20%, for example, 0.1%, 1%, 2%, 3%, 4%, 5%, 6%, 7%, 8%, 9%, 10%, 11%, 12%, 13%, 14%, 15%, 16%, 17%, 18%, 19%, or 20%, and preferably 1% to 5%. The content in percentage by weight of the organic solvent is 70% to 99.9%.

The present application further provides a colored photovoltaic module. The colored photovoltaic module includes a colored glass layer, a solar cell chip layer, a first lower flexible adhesive film layer, a reinforced adhesive film layer, a second lower flexible adhesive film layer, and a back glass layer laminated in sequence.

The colored glass layer includes an infrared reflective powder and a color developing powder. The choices of the infrared reflective powder and the color developing powder are as described in the section for the ink.

In a specific embodiment, the infrared reflective powder has a three-layer structure, including a first dielectric film layer, a metal film layer, and a second dielectric film layer laminated in sequence. The first dielectric film layer has a thickness of 10 nm to 100 nm, the metal film layer has a thickness of 3 nm to 30 nm, and the second dielectric film layer has a thickness of 10 nm to 100 nm.

In a specific embodiment, the infrared reflective powder is one or more selected from ZnS/Ag/ZnS, SiO₂/Ag/TiO₂, Al₂O₃/Ag/Al₂O₃, and ZnO/Ag/ZnS, and preferably ZnS/Ag/ZnS.

The colored glass layer may have two-type structures. One type includes a front glass layer, a colored enamel layer, and an upper adhesive film layer laminated in sequence. The upper adhesive film layer is closer to the solar cell chip layer than the front glass layer and the colored enamel layer are. The colored enamel layer includes the infrared reflective powder and the color developing powder. In the colored enamel layer, the content in percentage by weight of the infrared reflective powder is 0.1% to 30%, for example, 0.1%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, and preferably 5%% to 15%. The content in percentage by weight of the color developing powder is 0.1% to 20%, for example, 0.1%, 1%, 2%, 3%, 4%, 5%, 6%, 7%, 8%, 9%, 10%, 11%, 12%, 13%, 14%, 15%, 16%, 17%, 18%, 19%, 20%, and preferably 1% to 5%.

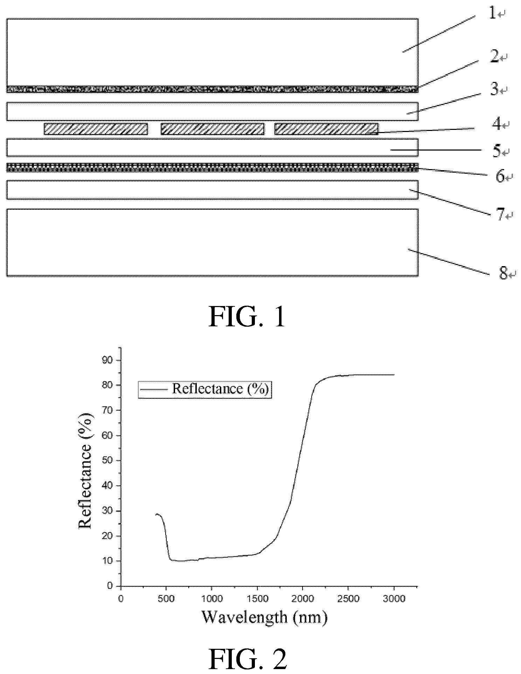

As shown in FIG. 1, the colored photovoltaic module of such a structure includes a front glass layer 1, a colored enamel layer 2, an upper adhesive film layer 3, a solar cell chip layer 4, a first lower flexible adhesive film layer 5, a reinforced adhesive film layer 6, a second lower flexible adhesive film layer 7 and a back glass layer 8 laminated in sequence.

The front glass layer 1 may have different choices in different application scenarios. For use in the field of building curtain walls, float ultra-white glass is preferred, which has a thickness of 2 mm to 16 mm depending on the design requirements, and whether to coat an antireflective film on the front surface of the glass is determined according to the actual needs. For use on decorative secondary roofs, 1 to 5 mm-thick ultra-white embossed or float glass may be used, and whether to coat an antireflective film on the front surface of the glass is determined according to the actual needs.

The colored enamel layer 2 is attached onto the front glass layer 1, by coating the ink including the infrared reflective powder and the color developing powder by screen printing or spraying, followed by sintering at a temperature in the range of 500°C to 800°C. The ink may be a high-temperature ink or a low-temperature ink mentioned in the present application.

In a specific embodiment, the colored enamel layer has a thickness of 5 µm to 100 µm, for example 5 µm, 10 µm, 20 µm, 30 µm, 40 µm, 50 µm, 60 µm, 70 µm, 80 µm, 90 µm, or 100 µm, and preferably 10 µm to 30 µm.

The upper adhesive film layer 2 may be colorless and transparent, or a colored adhesive film added with the infrared reflective powder and the color developing powder mentioned in the present application. That is, a colored adhesive film may be obtained by adding the infrared reflective powder and the color developing powder to the colorless and transparent adhesive film. The upper adhesive film layer 2 may be made of EVA, POE, PVB, SGP, and others.

In the second-type colored glass layer, the colored glass layer includes a front glass layer and an upper adhesive film layer laminated in sequence. The upper adhesive film layer is closer to the solar cell chip layer than the front glass layer is, and the upper adhesive film layer includes the infrared reflective powder and the color developing powder, corresponding to the case where the upper adhesive film layer is colored. In this type of colored glass layer, the reflection effect may be adjusted by adjusting the concentration of the powder in the upper adhesive film layer, or the reflection effect may be adjusted by adjusting the thickness of the upper adhesive film layer within a certain range. In the upper adhesive film layer, the content in percentage by weight of the infrared reflective powder is 0.1% to 30%, and preferably 5% to 15%; and the content in percentage by weight of the color developing powder is 0.1% to 20%, and preferably 1% to 5%. The thickness of the upper adhesive film layer may be 0.1 mm to 0.7 mm, for example, 0.1 mm, 0.2 mm, 0.3 mm, 0.4 mm, 0.5 mm, 0.6 mm, or 0.7 mm.

The colored glass layer includes the infrared reflective powder and the color developing powder, which can reduce the temperature of the photovoltaic module on the one hand, and enable the photovoltaic module to show various colors on the other hand, whereby the photovoltaic module can have colors and ensure high efficiency of the photovoltaic module.

In the present application, the solar cell chip layer may include multiple solar cell chips, and the multiple solar cell chip layers are sequentially arranged in an array at equal intervals. The solar cell chip may be a common single crystalline or polycrystalline solar cell chip, or other types of solar cell chips. The number of grid lines of the solar cell chip may be any number between 2 and 30. The solar cell chip may also be a back-contact solar cell chip, a solar cell chip with a shingled structure or a battery chip with a perforated metal structure and a corresponding connection structure.

In the present application, the first lower flexible adhesive film layer and the second lower flexible adhesive film layer are both one selected from an EVA film layer, a POE film layer, a PVB film layer or an SGP film layer.

Particularly, the first lower flexible adhesive film layer and the second lower flexible adhesive film layer may be the same film layer or different film layers.

In the present application, the reinforced adhesive film layer is one of a PET film layer, a PU film layer, a nylon layer, or a metal mesh layer.

The back glass layer may be transparent glass, or may be fully coated with a black enamel layer on an inner surface thereof or screen printed with a black enamel layer of a net structure in a gap between the solar cells. The thickness of the back glass layer may be 1 mm to 16 mm.

Further, the colored photovoltaic module of the present application may further include a ribbon, a bus bar, and a junction box for connecting the solar cell and conducting the current, and a cable for installing the module, etc.

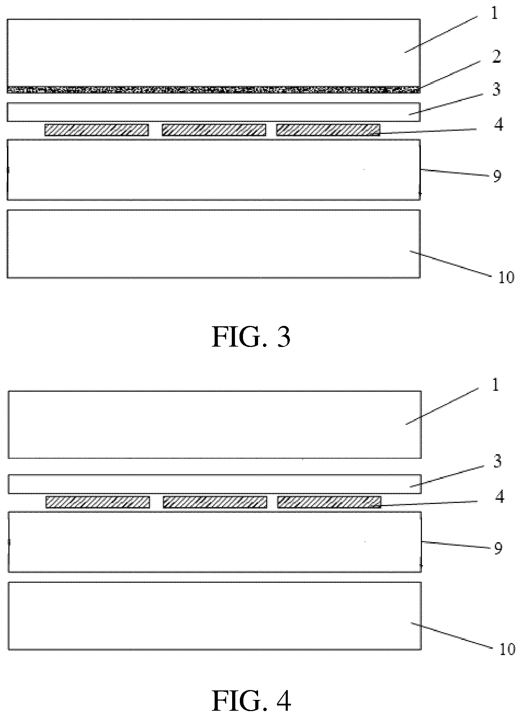

The present application further provides a colored photovoltaic module, which includes any infrared reflective powder and color developing powder as described above. Particularly, as shown in FIG. 3 and FIG. 4, the colored photovoltaic module includes a front glass layer 1, an upper adhesive film layer 3, a solar cell chip layer 4, a lower adhesive film layer 9 and a back sheet 10 laminated in sequence. The photovoltaic module includes the infrared reflective powder and the color developing powder on or in a front radiation receiving side thereof.

In the present application, the front radiation receiving side refers to an area above a light receiving side of the solar cell chip layer. The expression "including the infrared reflective powder and the color developing powder on or in a front radiation receiving side" means that the infrared reflective powder and the color developing powder may be located on an air side of the front glass layer (that is, the side of the front glass layer far away from the solar cell chip layer), a non-air side of the front glass layer (that is, the side of the front glass layer close to the solar cell chip layer), both sides of the upper adhesive film layer, or in the upper adhesive film layer, and so on.

In a specific embodiment, the colored photovoltaic module is highly transmissive to light with a wavelength of 300 nm to 1100 nm, and highly reflective to infrared light with a wavelength of 1100 nm to 5000 nm.

In a specific embodiment, the colored photovoltaic module being highly transmissive to light with a wavelength of 300 nm to 1100 nm means that the transmittance to light with a wavelength of 300 nm to 1100 nm is at least 50%, for example, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

In a specific embodiment, the colored photovoltaic module being highly reflective to infrared light with a wavelength of 1100 nm to 5000 nm means that the reflectance to infrared light with a wavelength of 1100 nm to 5000 nm is at least 25%, for example, 25%, 30%, 35%, 40%, 45%, 50%, 55%, 60%, 65%, 70%, 75%, 80%, 85%, or 90%.

A person skilled in the art can understand that for the colored photovoltaic module, the content of the infrared reflective powder is positively related to the reflectance of the colored photovoltaic module to infrared light with a wavelength of 1100 to 5000 nm, while other conditions are kept unchanged. By adjusting the content of the infrared reflective powder contained in the photovoltaic module, the reflectance of the colored photovoltaic module to infrared light with a wavelength of 1100 to 5000 nm can be adjusted, to meet different practical needs.

In a specific embodiment, as shown in FIG. 3, the colored photovoltaic module includes a front glass layer 1, a colored enamel layer 2, an upper adhesive film layer 3, a solar cell chip layer 4, a lower adhesive film layer 9 and a back sheet 10 laminated in sequence. The colored enamel layer 2 includes the infrared reflective powder and the color developing powder, that is, the infrared reflective powder and the color developing powder are located in the colored enamel layer 2.

In a specific embodiment, the colored photovoltaic module includes a colored enamel layer 2, a front glass layer 1, an upper adhesive film layer 3, a solar cell chip layer 4, a lower adhesive film layer 9 and a back sheet 10 laminated in sequence. The colored enamel layer 2 includes the infrared reflective powder and the color developing powder, that is, the infrared reflective powder and the color developing powder are located in the colored enamel layer 2.

The colored enamel layer 2 may further include an additional ingredient, such as a glass powder.

In a specific embodiment, the colored enamel layer 2 is attached to both sides of the front glass layer 1 (or an air side or a non-air side of the front glass layer), and is formed by any high-temperature ink or low-temperature ink mentioned in the present application. For example, the colored enamel layer may be obtained by coating a high-temperature ink or low-temperature ink including the infrared reflective powder and the color developing powder by screen printing or spraying, followed by sintering at a temperature in the range of 500°C to 800°C.

The lower adhesive film layer 9 may be any type of adhesive film layer known in the art. For example, the lower adhesive film layer 9 may be a mono-layer flexible film layer, such as any one of an EVA film layer, a POE film layer, a PVB film layer or an SGP film layer. Alternatively, as described above, as shown in FIG. 1, the lower adhesive film layer 9 includes a first lower flexible adhesive film layer 5, a reinforced adhesive film layer 6, and a second lower flexible adhesive film layer 7 laminated in sequence.

The back sheet 10 may be any type of back sheet known in the art, for example, a back sheet made of a glass material, that is, the glass layer shown in FIG. 1, or a back sheet made of a polymer material.

In a specific embodiment, as shown in FIG. 4, the colored photovoltaic module includes a front glass layer 1, an upper adhesive film layer 3, a solar cell chip layer 4, a lower adhesive film layer 9 and a back sheet 10 laminated in sequence. The upper adhesive film layer 3 includes the infrared reflective powder and the color developing powder, that is, the infrared reflective powder and the color developing powder are located in the upper adhesive film layer 3. The infrared reflective powder and the color developing powder are added to the upper adhesive film layer 3 by a method known in the art.

In this type of colored photovoltaic module, the reflection effect may be adjusted by adjusting the content of the infrared reflective powder in the upper adhesive film layer 3, or the reflection effect may be adjusted by adjusting the thickness of the upper adhesive film layer 3 within a certain range. Further, to ensure the uniformity of the infrared reflective powder and the color developing powder, the upper adhesive film 3 may be divided into two layers. One layer contains the infrared reflective powder and the color developing powder, and has a thickness of 0.05 mm to 0.3 mm. The other layer is a transparent layer without the infrared reflective powder and the color developing powder, and having a thickness of 0.2 mm to 1 mm, to meet the requirements of sealing and insulation. These two layers are combined into the upper adhesive film by co-extrusion.

In a specific embodiment, in the upper adhesive film layer 3, the content in percentage by weight of the infrared reflective powder is 0.1% to 30%, and preferably 5% to 15%; and the content in percentage by weight of the color developing powder is 0.1% to 20%, and preferably 1% to 5%.

In a specific embodiment, the thickness of the upper adhesive film layer 3 may be 0.1 mm to 0.7 mm, for example, 0.1 mm, 0.2 mm, 0.3 mm, 0.4 mm, 0.5 mm, 0.6 mm, or 0.7 mm.

### Examples

### Example 1

10 g of ZnS (38 nm)/Ag (10 nm)/ZnS (40 nm), 3 g of a commercially available blue pearlescent powder, 67 g of a commercially available glass powder, and 20 g of an organic solvent as a dispersion medium were fully stirred and mixed, and further uniformly mixed by using a three-roll grinder, to form a finished high-temperature ink.

The ZnS/Ag/ZnS infrared reflective powder was prepared by a method as follows: A Si(111) wafer having one polished side surface and planar K9 glass with a thickness of 2 mm were used as a substrate, and ZnS was deposited by electron beam evaporation using a vacuum box coater. After a first layer of ZnS was deposited, a Ag film layer was prepared by resistive thermal evaporation in the vacuum box coater using high-purity silver particles as an evaporation source. Then, a third layer of ZnS film was prepared by the same method as that for the first layer of ZnS. After the multilayer film was prepared, it was peeled off from the substrate and crushed to obtain the infrared reflective powder.

The finished high-temperature ink was printed on an inner surface of ultra-white glass by screen printing, spraying, or roller coating, and dried in an infrared heating tunnel furnace at 150°C to 250°C, to prepare a colored enamel layer on the inner side surface of the ultra-white glass. The thickness of the ultra-white glass was 3.2 mm, and the thickness of the colored enamel layer was 20 µm. After the drying, transparent colored glass was obtained by tempering in a tempering furnace.

The colored glass, a welded solar cell array, EVA, black PET, POE, and other adhesive films, and back glass were laminated, and pressed in a pressing machine at 140°C to 150°C for about 20 min, to form a colored module.

As tested, the prepared colored module has a reflectance curve as shown in FIG. 2. The reflectance is about 30% in the blue light band, the average reflectance is 53% in the infrared band of 1100 nm or higher, and the average reflectance is more than 80% in the infrared band of 1700 nm or higher. Because the module receives fewer infrared rays, the measured working temperature of the module is 3°C to 10°C lower than that of a common module under the same environment.

### Examples 2 to 4

In Examples 2 to 4, the same method as that in Example 1 was used to prepare a colored module, except that the amount of the infrared reflective powder was different.

Particularly, the amount of the infrared reflective powder in Example 2 was 5 g, the amount of the infrared reflective powder in Example 3 was 15 g, and the amount of the infrared reflective powder in Example 4 was 3 g.

### Examples 5 to 6

In Examples 5 to 6, the same method as that in Example 1 was used to prepare a colored module, except that the type of the infrared reflective powder was different.

Particularly, the infrared reflective powder in Example 5 was SiO₂ (38 nm)/Ag (10 nm)/TiO₂ (40 nm), and the infrared reflective powder in Example 6 was Al₂O₃ (38 nm)/Ag (10 nm)/Al₂O₃ (40 nm).

### Example 7

9 g of ZnS (38 nm)/Ag (10 nm)/ZnS (40 nm), 1 g of red multi-layer oxide nano-powder, 90 g of n-butyl acrylate, and a thermal initiator (azobisisobutyronitrile) were fully stirred and mixed, to form a finished low-temperature ink.

The red multi-layer oxide nano-powder was prepared by a method as follows: K9 glass was used as a substrate, a release agent was coated on the glass surface, TiO₂ and SiO₂ materials were sequentially deposited as films on the substrate by electron beam deposition using a vacuum box coater, to form a multi-layer oxide film. After the deposition, the film was released and crushed to obtain a red multilayer oxide nano-powder.

The finished low-temperature ink was printed on an inner surface of ultra-white glass by screen printing, spraying or roller coating, and dried in an infrared heating tunnel furnace at 150°C to 250°C, to prepare a colored enamel layer on the inner side surface of the ultra-white glass. The thickness of the ultra-white glass was 2 mm, and the thickness of the colored enamel layer was 25 µm. After drying, transparent colored glass was obtained by tempering in a tempering furnace, and thermally solidifying in an infrared heating tunnel furnace.

The colored glass, a welded solar cell array, EVA, black PET, POE, and other adhesive films, and back glass were laminated, and pressed in a pressing machine at 140°C to 150°C for about 20 min, to form a colored module.

### Example 8

In Example 8, the same method as that in Example 7 was used to prepare a colored module, except that the amount of the infrared reflective powder was different.

Particularly, the amount of the infrared reflective powder in Example 8 was 4 g.

### Examples 9 to 10

In Examples 9 to 10, the same method as that in Example 7 was used to prepare a colored module, except that the type of the infrared reflective powder was different.

Particularly, the infrared reflective powder in Example 9 was SiO₂ (38 nm)/Ag (10 nm)/TiO₂ (40 nm), and the infrared reflective powder in Example 10 was Al₂O₃ (38 nm)/Ag (10 nm)/Al₂O₃ (40 nm).

### Example 11

Different from Example 1, ZnS/Ag/ZnS and blue pearlescent powder were located in the upper adhesive film layer in Example 11, but not present as a colored enamel layer, and the content of the blue pearlescent powder was also different.

Particularly, 10 g of ZnS/Ag/ZnS and 5 g of commercially available blue pearlescent powder were mixed with 85 g of EVA particles and an additive, heated to melt, mixed by stirring until uniform, and extruded to form a 0.1 mm-thick colored EVA adhesive film layer. The colored adhesive film layer was co-extruded with a 0.4 mm-thick transparent EVA adhesive film layer, and used as the upper adhesive film layer (having the same thickness of 0.5 mm as the upper EVA adhesive film layer in Examples 1 to 10).

### Comparative Example 1

Comparative Example 1 differed from Example 1 in that the prepared high-temperature ink did not contain the infrared reflective powder.

Specifically, 3 g of blue pearlescent powder, 67 g of glass powder, and 30 g of an organic solvent as a dispersion medium, were fully stirred and mixed, and further uniformly mixed by using a three-roll grinder, to form a finished high-temperature ink.

The specific compositions of the inks in the above examples and comparative examples, and the working temperature and average reflectance to infrared light with a wavelength of 1100 nm or more of the colored modules prepared in the examples and the comparative example are shown in Table 1.

**Table 1. Compositions of inks and test results of colored modules in the examples and the comparative example**

| | Type of ink | Type of infrared reflective powder | Infrared reflective powder (g) | Color developing powder (g) | Glass powder (g) | Organic solvent (g) | Average reflectance to infrared light with a wavelength of 1100 nm or more |
|---|---|---|---|---|---|---|---|
| Example 1 | High temperature. | ZnS/Ag/ZnS | 10 | 3 | 67 | 20 | 53% |
| Example 2 | High temperature. | ZnS/Ag/ZnS | 5 | 3 | 67 | 25 | 43% |
| Example 3 | High temperature. | ZnS/Ag/ZnS | 15 | 3 | 67 | 15 | 65% |
| Example 4 | High temperature. | ZnO/Ag/ZnS | 3 | 3 | 67 | 27 | 26% |
| Example 5 | High temperature. | SiO_{2/}Ag/TiO₂ | 10 | 3 | 67 | 20 | 49% |
| Example 6 | High temperature. | Al₂O₃/Ag/Al₂O₃ | 10 | 3 | 67 | 20 | 50% |
| Example 7 | Low temperature | ZnS/Ag/ZnS | 9 | 1 | 0 | 90 | 50% |
| Example 8 | Low temperature | ZnS/Ag/ZnS | 4 | 1 | 0 | 95 | 35% |
| Example 9 | Low temperature | SiO₂/Ag/TiO₂ | 9 | 1 | 0 | 90 | 49% |
| Example 10 | Low temperature | Al₂O₃/Ag/Al₂O₃ | 9 | 1 | 0 | 90 | 50% |
| Example 11 | | ZnS/Ag/ZnS | 10 | 5 | | | 58% |
| Comparative Example 1 | High temperature. | None | 0 | 3 | 67 | 30 | 4% |

In the description provided herein, many specific details are set forth. However, it can be understood that the embodiments of the present application can be practiced without the specific details. In some instances, well-known methods, structures, and techniques are not shown in detail so as not to obscure the understanding of this specification.

In the claims, any reference numerals placed in parentheses shall not be constructed as limitations on the claims. The terms such as "comprise" and variants thereof do not exclude the presence of elements or steps not listed in the claims. The terms such as "a" or "an" before an element does not exclude the presence of plural such elements. The present invention can be implemented by means of hardware including a plurality of different elements and by means of a suitably programmed computer. In an individual claim enumerating a plurality of means, several of these means can be embodied by the same hardware. The use of the terms such as first, second, and third does not indicate any order. These terms can be interpreted as names.

Finally, it should be noted that the above-described embodiments are merely illustrative of, and not intended to limit the technical solutions of the present invention. Although the present invention has been described in detail with reference to the foregoing embodiments, those of ordinary skill in the art should understand that the technical solutions described in the above various embodiments can be modified, or some of the technical features therein can be equivalently substituted. Such modifications and substitutions do not cause the nature of the corresponding technical solution to depart from the spirit and scope of the embodiments of the present invention.

## Claims

1. An ink, comprising an infrared reflective powder and a color developing powder, wherein in the ink, the content in percentage by weight of the infrared reflective powder is 0.1% to 30%, and preferably 5% to 15%; and the content in percentage by weight of the color developing powder is 0.1% to 20%, and preferably 1% to 5%.

2. The ink according to claim 1, wherein the infrared reflective powder is highly transmissive to light with a wavelength of 300 nm to 1100 nm, and highly reflective to infrared light with a wavelength of 1100 nm to 5000 nm.

3. The ink according to claim 1, wherein the infrared reflective powder is of transparent or translucent flakes with a thickness of 0.5 µm to 5 µm, and the color developing powder is of transparent or translucent flakes with a thickness of 0.5 µm to 5 µm.

4. The ink according to claim 1, wherein the infrared reflective powder comprises a first dielectric film layer, a metal film layer, and a second dielectric film layer laminated in sequence, wherein the first dielectric film layer has a thickness of 10 nm to 100 nm, the metal film layer has a thickness of 3 nm to 30 nm, and the second dielectric film layer has a thickness of 10 nm to 100 nm.

5. The ink according to claim 4, wherein the infrared reflective powder is one or more selected from ZnS/Ag/ZnS, SiO₂/Ag/TiO₂, Al₂O₃/Ag/Al₂O₃, and ZnO/Ag/ZnS, and preferably ZnS/Ag/ZnS.

6. The ink according to claim 1, wherein the ink is a high-temperature ink, comprising the infrared reflective powder, the color developing powder, a glass powder, and an organic solvent.

7. The ink according to claim 6, wherein in the high-temperature ink, the content in percentage by weight of the infrared reflective powder is 0.1% to 30%, and preferably 5% to 15%; the content in percentage by weight of the color developing powder is 0.1% to 20%, and preferably 1% to 5%; the content in percentage by weight of the glass power is 30% to 70%; and the content in percentage by weight of the organic solvent is 10% to 40%.

8. The ink according to claim 1, wherein the ink is a low-temperature ink, comprising the infrared reflective powder, the color developing powder, and an organic solvent.

9. The ink according to claim 8, wherein in the low-temperature ink, the content in percentage by weight of the infrared reflective powder is 0.1% to 30%, and preferably 5% to 15%; the content in percentage by weight of the color developing powder is 0.1% to 20%, and preferably 1% to 5%; and the content in percentage by weight of the organic solvent is 70% to 99.9%.

10. A colored photovoltaic module, comprising a colored glass layer, a solar cell chip layer (4), a first lower flexible adhesive film layer (5), a reinforced adhesive film layer (6), a second lower flexible adhesive film layer (7), and a back glass layer (8) laminated in sequence.

11. The colored photovoltaic module according to claim 10, wherein the colored glass layer comprises a front glass layer, a colored enamel layer (2), and an upper adhesive film layer (3) laminated in sequence, wherein the upper adhesive film layer (3) is closer to the solar cell chip layer (4) than the front glass layer and the colored enamel layer (2) are.

12. The colored photovoltaic module according to claim 11, wherein the colored enamel layer (2) comprises an infrared reflective powder and a color developing powder, wherein in the colored enamel layer (2), the content in percentage by weight of the infrared reflective powder is 0.1% to 30%, and preferably 5% to 15%; and the content in percentage by weight of the color developing powder is 0.1% to 20%, and preferably 1% to 5%.

13. The colored photovoltaic module according to claim 11, wherein the colored enamel layer (2) has a thickness of 5 µm to 100 µm, and preferably 10 µm to 30 µm.

14. The colored photovoltaic module according to claim 11, wherein the colored enamel layer (2) is formed of an ink according to any one of claims 1 to 9.

15. The colored photovoltaic module according to claim 10, wherein the colored glass layer comprises a front glass layer and an upper adhesive film layer (3) laminated in sequence, wherein the upper adhesive film layer (3) is closer to the solar cell chip layer (4) than the front glass layer is; and
the upper adhesive film layer (3) comprises an infrared reflective powder and a color developing powder, wherein in the upper adhesive film layer (3), the content in percentage by weight of the infrared reflective powder is 0.1% to 30%, and preferably 5% to 15%; and the content in percentage by weight of the color developing powder is 0.1% to 20%, and preferably 1% to 5%.

16. The colored photovoltaic module according to claim 12 or 15, wherein the infrared reflective powder is highly transmissive to light with a wavelength of 300 nm to 1100 nm, and highly reflective to infrared light with a wavelength of 1100 nm to 5000 nm.

17. The colored photovoltaic module according to claim 12 or 15, wherein the infrared reflective powder is of transparent or translucent flakes with a thickness of 0.5 µm to 5 µm, and the color developing powder is of transparent or translucent flakes with a thickness of 0.5 µm to 5 µm.

18. The colored photovoltaic module according to claim 12 or 15, wherein the infrared reflective powder comprises a first dielectric film layer, a metal film layer, and a second dielectric film layer laminated in sequence, wherein the first dielectric film layer has a thickness of 10 nm to 100 nm, the metal film layer has a thickness of 3 nm to 30 nm, and the second dielectric film layer has a thickness of 10 nm to 100 nm.

19. The colored photovoltaic module according to claim 17, wherein the infrared reflective powder is on or more selected from ZnS/Ag/ZnS, SiO₂/Ag/TiO₂, Al₂O₃/Ag/Al₂O₃, and ZnO/Ag/ZnS, and preferably ZnS/Ag/ZnS.

20. A colored photovoltaic module, comprising a front glass layer, an upper adhesive film layer (3), a solar cell chip layer (4), a lower adhesive film layer (9), and a back sheet (10) laminated in sequence; and the photovoltaic module comprising an infrared reflective powder and a color developing powder on or in a front radiation receiving side thereof.

21. The colored photovoltaic module according to claim 20, wherein the colored photovoltaic module is highly transmissive to light with a wavelength of 300 nm to 1100 nm, and highly reflective to infrared light with a wavelength of 1100 nm to 5000 nm.

22. The colored photovoltaic module according to claim 20, wherein the infrared reflective powder is of transparent or translucent flakes with a thickness of 0.5 µm to 5 µm, and the color developing powder is of transparent or translucent flakes with a thickness of 0.5 µm to 5 µm.

23. The colored photovoltaic module according to claim 20, wherein the infrared reflective powder comprises a first dielectric film layer, a metal film layer, and a second dielectric film layer laminated in sequence, wherein the first dielectric film layer has a thickness of 10 nm to 100 nm, the metal film layer has a thickness of 3 nm to 30 nm, and the second dielectric film layer has a thickness of 10 nm to 100 nm.

24. The colored photovoltaic module according to claim 23, wherein the infrared reflective powder is one or more selected from ZnS/Ag/ZnS, SiO₂/Ag/TiO₂, Al₂O₃/Ag/Al₂O₃, and ZnO/Ag/ZnS, and preferably ZnS/Ag/ZnS.

25. The colored photovoltaic module according to claim 20, comprising a colored enamel layer (2) arranged between the front glass layer and the upper adhesive film layer (3) or at an air side of the front glass layer, wherein the colored enamel layer (2) comprises the infrared reflective powder and the color developing powder.

26. The colored photovoltaic module according to claim 25, wherein the colored enamel layer (2) is formed of an ink according to any one of claims 1 to 9.

27. The colored photovoltaic module according to claim 20, wherein the upper adhesive film layer (3) comprises the infrared reflective powder and the color developing powder.

28. The colored photovoltaic module according to claim 27, wherein in the upper adhesive film layer (3), the content in percentage by weight of the infrared reflective powder is 0.1% to 30%, and preferably 5% to 15%; and the content in percentage by weight of the color developing powder is 0.1% to 20%, and preferably 1% to 5%.

29. The colored photovoltaic module according to claim 20, wherein the lower adhesive film layer (9) comprises a first lower flexible adhesive film layer (5), a reinforced adhesive film layer (6), and a second lower flexible adhesive film layer (7) laminated in sequence.
